# EUROPEAN PATENT SPECIFICATION

(11) **EP 4 597 575 B1**
(45) Date of publication and mention of the grant of the patent: **16.09.2026**
(21) Application number: 22961501.8
(22) Date of filing: 04.10.2022
(51) Int. Cl.: H10H 29/30, H10H 29/85, H10H 29/855

(54) **TRANSPARENT DISPLAY DEVICE USING LIGHT-EMITTING DIODE**
TRANSPARENTE ANZEIGEVORRICHTUNG MIT LEUCHTDIODE
DISPOSITIF D'AFFICHAGE TRANSPARENT UTILISANT UNE DIODE ÉLECTROLUMINESCENTE

(43) Date of publication of application: 06.08.2025
(73) Proprietor: LG Electronics Inc., Yeongdeungpo-gu Seoul 07336 (KR)
(72) Inventor: KIM, Baekjun, Seoul 06772 (KR); HONG, Daewoon, Seoul 06772 (KR); JEONG, Chansung, Seoul 06772 (KR); OH, Jeongtak, Seoul 06772 (KR)
(74) Representative: Frenkel, Matthias Alexander
(86) International application number: PCT/KR2022/014871
(87) International publication number: WO 2024/075856

(56) References cited:
- WO-A1-2022/197053
- JP-A- 2006 301 650
- JP-A- 2010 034 183
- KR-A- 20200 026 769
- KR-A- 20200 114 055
- KR-B1- 102 276 372
- US-A1- 2018 206 298
- US-A1- 2018 247 922
- US-A1- 2021 043 618
- US-A1- 2021 399 041
- US-A1- 2022 262 995

## Description

### TECHNICAL FIELD

The present invention is applicable to the technical field related to display devices, and for example, relates to a transparent display device using a Light Emitting Diode (LED).

### BACKGROUND ART

Recently, in a field of a display technology, display devices having excellent characteristics such as thinness, flexibility, and the like are developed. On the other hand, currently commercialized major displays are represented by LCDs (liquid crystal displays) and OLEDs (organic light emitting diodes).

On the other hand, light emitting diodes (LEDs) are semiconductor light emitting elements well known as converting current into light, and starting with commercialization of red LEDs using GaAsP compound semiconductors in 1962, they are used as light sources for display images in electronic devices including information and communication devices along with GaP:N-based green LEDs.

Recently, these light emitting diodes (LEDs) have been gradually miniaturized and are fabricated as micrometer-sized LEDs to be used as pixels or flat lights for display devices.

Such micro LED technology shows characteristics of low power, high luminance, and high reliability compared to other display devices/panel, and is also applicable to flexible devices. Therefore, it has been actively studied in research institutes and companies in recent years.

On the other hand, it is possible to implement an LED film transparent display device that can be configured transparently using LEDs, which is a display device in which an LED is configured as a light source or one pixel on a thin film-type base.

A transparent LED film of the related art uses a package-type LED as a light source, and both electrodes and wiring patterns of the light source may be formed on a transparent film base surface.

Red, green, and blue LEDs and a control IC (drive chip) are disposed as one pixel on the transparent film base surface, and each pixel may be disposed on the film in the form of a matrix at regular intervals. All regions except for the light source and the control IC may be made of a transparent material, and transmittance at this time may be determined by a size of the light source and a size of the control IC.

In this way, a viewing angle of a transparent film may be determined based on a pitch of an LED light source applied to the transparent film and performance of the light source.

However, due to the characteristics of the light source that uses red, green, and blue LEDs, the mixing of red, green, and blue colors may not be well performed, resulting in problems such as left and right color deviations at a specific viewing angle and the like.

In addition, a transparent resin layer is used for an encapsulant and the like, but transmittance is not high at visible light wavelengths, which may cause problems such as a decrease in luminance of a light source and the like.

Therefore, there is a need for a way to solve these problems.

US 2021/399041 A1 and

US 2021/043618 A1 disclose an LED display device including a plurality of light sources installed on a base to constitute individual pixels, each of the light sources including a first, second and third LED to constitute a sub-pixel.

WO 2022/197053 A1 discloses an LED display device including a plurality of light sources installed on a base, each of the light sources including an encapsulation layer, a first micro lens array formed in an upper surface of the encapsulation layer, a cover layer disposed on the encapsulation layer, and a second micro lens array formed in an upper surface of the cover layer.

### DISCLOSURE

### TECHNICAL TASKS

According to an embodiment of the present disclosure, it is intended to provide a transparent display device using a light emitting device capable of improving color uniformity and implementing the same to satisfy various light emitting characteristics.

In addition, according to an embodiment of the present disclosure, it is intended to provide a transparent display device capable of improving a directional angle of a light source and allowing the light source to have a uniform viewing angle.

In addition, according to an embodiment of the present disclosure, it is intended to provide a transparent display device capable of improving color reproducibility by making a light source have a flat top surface effect and adjusting the overall thickness of a transparent display.

### TECHNICAL SOLUTIONS

According to the present invention, a transparent display device is set forth in claim 1 and preferred embodiments are provided in the dependent claims.

The transparent display device includes a transparent base, a plurality of light sources installed on the transparent base to constitute individual pixels, a planarization layer provided to cover the light source, and a cover layer disposed on the planarization layer, wherein each of the light sources may include a wiring substrate, a light emitting unit positioned on the wiring substrate and having a first light emitting device, a second light emitting device, and a third light emitting device to constitute a sub-pixel, a driving chip driving the light emitting unit and disposed on the wiring substrate, an encapsulation layer disposed on the wiring substrate to cover the light emitting unit and the driving chip, a first lens including a micro lens array disposed on the encapsulation layer, and a second lens disposed on the micro lens array, wherein the second lens has a single convex lens shape.

The second lens may be formed to cover the light source entirely.

The second lens may be directly formed on the first lens.

### ADVANTAGEOUS EFFECTS

According to an exemplary embodiment of the present disclosure, the following effects are obtained.

First, the present disclosure may improve desired color uniformity by various combinations of a lens structure, a unit lens, and a light scattering agent, and may be implemented to satisfy various light emitting characteristics.

In addition, according to an embodiment of the present disclosure, a directional angle of a light source may be improved. In addition, the light source may have a uniform viewing angle.

Such a uniform viewing angle allows a user to feel similar light intensity at various angles, thereby increasing the affinity of a transparent display.

Accordingly, the use environment of the transparent display may be variously created, thereby being further expanded.

In addition, according to an embodiment of the present disclosure, color reproducibility may be improved by allowing a light source to have a flat top surface effect, and the overall thickness of a transparent display may be adjusted.

### DESCRIPTION OF DRAWINGS

FIG. 1 is a schematic cross-sectional diagram illustrating a transparent display device according to a first example not forming part of the present invention.
FIG. 2 is a schematic cross-sectional diagram illustrating a transparent display device according to a second example not forming part of the present invention.
FIG. 3 is a schematic cross-sectional diagram illustrating a transparent display device according to a third example not forming part of the present invention.
FIG. 4 is a schematic cross-sectional diagram illustrating a transparent display device according to a fourth example not forming part of the present invention.
FIG. 5 is a schematic cross-sectional diagram illustrating a transparent display device according to a fifth example not forming part of the present invention.
FIG. 6 is a photograph illustrating a micro lens array shape of the transparent display device according to the fifth example of the present invention.
FIG. 7 is a schematic cross-sectional diagram illustrating a transparent display device according to a sixth example not forming part of the present invention.
FIG. 8 is a schematic cross-sectional diagram illustrating a transparent display device according to a seventh example not forming part of the present invention.
FIG. 9 is a schematic cross-sectional diagram illustrating a transparent display device according to an eighth example not forming part of the present invention.
FIG. 10 is a schematic cross-sectional diagram illustrating a transparent display device according to a first embodiment of the present invention.
FIG. 11 is a schematic cross-sectional diagram illustrating a transparent display device according to a second embodiment of the present invention.
FIG. 12 is a schematic cross-sectional diagram illustrating a transparent display device according to third embodiment of the present invention.
FIG. 13 is a schematic cross-sectional diagram illustrating a transparent display device according to a fourth embodiment of the present invention.
FIG. 14 is a graph illustrating a directional angle pattern of a light emitting device of a transparent display device according to an implementation of the present disclosure.
FIG. 15 is a graph showing a directional angle pattern when a lens structure of a transparent display device according to an implementation of the present disclosure is applied.
FIGS. 16 to 18 are graphs showing directional angle patterns when a light scattering agent of a transparent display device according to an implementation of the present disclosure is applied.
FIGS. 19 and 20 are conceptual diagrams illustrating relative positions of a light emitting device and a driving chip.
FIGS. 21 and 22 are cross-sectional schematic views illustrating distribution of a light scattering agent.

### BEST MODE

Reference will now be made in detail to embodiments of the present invention which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification. In addition, it should be noted that the accompanying drawings are only for easy understanding of the embodiments disclosed in the present specification, and should not be construed as limiting the technical scope of the invention defined by the claims.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

A display device described in the present specification is a concept including all display devices that display information with a unit pixel or a set of unit pixels. Therefore, it is not limited to a finished product, but may also be applied to components. For example, a panel corresponding to one part of a digital TV corresponds to a display device in the present specification. The finished product may include a mobile phone, a smart phone, a laptop computer, a digital broadcasting terminal, personal digital assistants (PDA), a PMP (portable multimedia player), a navigation system, a slate PC, a tablet PC, an ultra book, a digital TV, a desktop computer, and the like.

However, those skilled in the art may easily see that the configuration according to an embodiment described in the present specification is applicable to devices capable of display, even if it is a new product type to be developed later.

Semiconductor light emitting elements described herein conceptually include LEDs, mini-LEDs, micro-LEDs, etc., and such terms may be used interchangeably.

Hereinafter, each embodiment will be described with reference to the drawings. Hereinafter, descriptions of items commonly applied to each embodiment may be omitted.

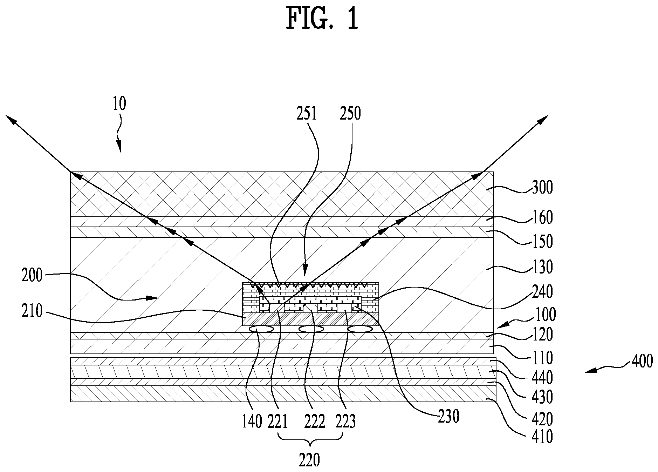

FIG. 1 is a schematic cross-sectional diagram illustrating a transparent display device according to a first example not forming part of the present invention.

Referring to FIG. 1, in a transparent display device 10, a plurality of light sources 200 defining a plurality of unit pixel areas may be installed on a transparent base 100.

A planarization layer 130 covering a plurality of the light sources 200 may be positioned on the unit pixel areas. The planarization layer 130 may flatly cover an upper side of a pixel area where a plurality of the light sources 200 are positioned. The planarization layer 130 may be formed of Optically Clear Resin (OCR).

A cover layer 150 may be positioned on the planarization layer 130. An Optically Clear Adhesive (OCA) layer 160 attached to a transparent wall surface such as glass may be positioned on the cover layer 150.

Therefore, the transparent display device 10 may be attached to a transparent wall surface such as glass by the OCA layer 160 to implement a display on the transparent wall surface.

In this case, refractive indexes of the planarization layer 130 and the OCA layer 160 may be substantially the same. For example, the planarization layer 130 and the OCA layer 160 may have a refractive index of 1.4.

A refractive index of the cover layer 150 may be greater than that of the planarization layer 130 or the OCA layer 160. For example, the cover layer 150 may be formed of a PET film, and thus the refractive index may be 1.53. Such a refractive index may be similar to the refractive index 1.51 of the glass constituting the transparent wall surface.

As an exemplary implementation, a functional layer 400 may be positioned on one side of the transparent base 100, that is, in a direction opposite to the cover layer 150.

For example, the functional layer 400 may include an EMI removing layer 430 for removing ElectroMagnetic Interference (EMI).

The EMI removing layer 430 may be positioned in a manner of being attached to a cover substrate 410 by a first adhesive layer 420. Also, the EMI removing layer 430 may be attached to the transparent base 100 by a second adhesive layer 440. In this case, the first adhesive layer 420, the EMI removing layer 430, and the second adhesive layer 440 may be optically clear all.

The functional layer 400 may include a layer having various functions as well as the EMI removing layer 430. Of course, the EMI removing layer 430 may be excluded from the functional layer 400.

The transparent base 100 may include a transparent film layer 110 and a wiring electrode layer 120 positioned on the transparent film layer 110. The light source 200 may be electrically connected to and installed on the wiring electrode layer 120 to constitute an individual pixel.

In this case, the individual light source 200 may include a wiring substrate 210, a light emitting unit 220 positioned on the wiring substrate 210 and including a first light emitting device 221, a second light emitting device 222, and a third light emitting device 223 to constitute a sub-pixel and a driving chip 230 driving the light emitting unit 220. The light emitting unit 220 may be electrically connected to the wiring electrode layer 120 by a conductive adhesive layer 140, for example, solder, conductive ball, etc.

Here, the driving chip 230 may be disposed on one side of the first light emitting device 221, the second light emitting device 222, and the third light emitting device 223 at a predetermined distance. In this case, the predetermined distance may be a distance equal to or greater than an effective distance for preventing light emitted from the light emitting unit 220 from being blocked. This will be described later.

On the wiring substrate 210, the light emitting unit 220 including the first light emitting device 221, the second light emitting device 222, and the third light emitting device 223 and a wiring (not shown) electrically connecting the driving chip 230 that drives the light emitting unit 220. A description of the wiring will be omitted.

An encapsulation layer (or encapsulant) 240 may be positioned on the wiring substrate 210 to cover the light emitting unit 220 and the driving chip 230. Also, a lens structure 250 may be positioned on the encapsulation layer 240.

In the present implementation, the lens structure 250 includes a micro lens array 251 positioned on an upper surface of the encapsulation layer 240. The micro lens array 251 may be directly formed on the encapsulation layer 240.

For example, the micro lens array 251 may be formed to have a predetermined pattern on the encapsulation layer 240. Such a pattern shape may have various shapes such as a hemisphere (dome) shape, a cone shape, a pyramid shape and the like.

Such a pattern shape may be formed using, for example, transfer molding, injection molding, etc.

Also, for another example, such a pattern shape may be formed using a mold patterning method. Such a mold patterning method may include Electro Discharging Machining (EDM) or etching.

In this case, the encapsulation layer 240 may be made of a resin such as epoxy, silicon, or the like. Therefore, the lens structure 250 including the micro lens array 251 may also be made of the same material.

In this way, an arbitrary incident angle may be formed by adding a lens function to the encapsulation layer 240, and thus a wide direction angle may be formed. Also, the micro lens array 251 may improve light extraction efficiency. That is, light emitted from the light emitting unit 220 may be efficiently extracted to the outside.

As described above, for example, the planarization layer 130 and the OCA layer 160 may have a refractive index of 1.4. A refractive index of the cover layer 150 may be greater than the refractive index of the planarization layer 130 and the OCA layer 160. For example, the cover layer 150 may be made of a PET film, and thus the refractive index may be 1.53. Such a refractive index may be similar to a refractive index (1.5) of the glass constituting a transparent wall surface. Also, the refractive index of the encapsulation layer 240 and the lens structure 250 may be, for example, 1.4 to 1.6.

By the arrangement of the refractive index and the lens structure 250, the light emitted from the light emitting unit 220 may be effectively extracted through the glass forming the transparent wall surface.

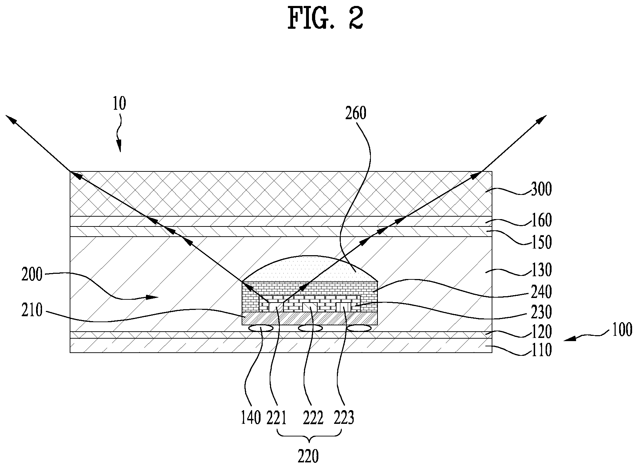

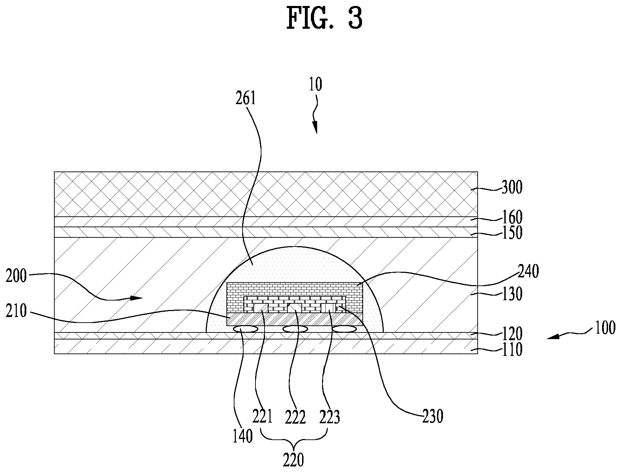

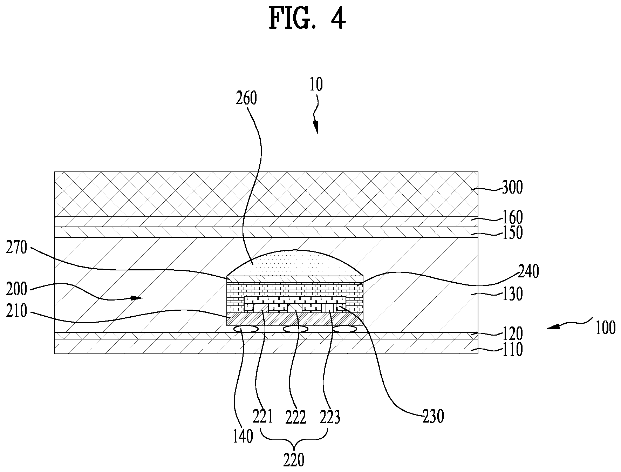

FIG. 2 is a schematic cross-sectional diagram showing a transparent display device according to a second example not forming part of the present invention. FIG. 3 is a schematic cross-sectional diagram showing a transparent display device according to a third example not forming part of the present invention. FIG. 4 is a schematic cross-sectional diagram showing a transparent display device according to a fourth example not forming part of the present invention.

Referring to FIG. 2, in a transparent display device 10, a plurality of light sources 200 defining a plurality of unit pixel areas may be installed on a transparent base 100.

A planarization layer 130 covering a plurality of the light sources 200 may be positioned on the unit pixel areas. The planarization layer 130 may flatly cover an upper side of the pixel areas where a plurality of the light sources 200 are positioned. The planarization layer 130 may be formed of an Optically Clear Resin (OCR).

A cover layer 150 may be positioned on the planarization layer 130. An Optically Clear Adhesive (OCA) layer 160 attached to a transparent wall surface such as glass may be positioned on the cover layer 150.

Therefore, the transparent display device 10 may be attached to the transparent wall surface such as glass by the OCA layer 160 to implement a display on the transparent wall surface.

Parts excluding the light source 200 may be common in each implementation. Therefore, in the following implementation, the light source 200 will be mainly described. The parts described with reference to FIG. 1 may be commonly applicable to the parts not mentioned in the following description may be commonly applied.

As shown in FIG. 2, according to a second implementation, an individual light source 200 may include a wiring substrate 210, a light emitting unit 220 positioned on the wiring substrate 210 and including a first light emitting device 221, a second light emitting device 222, and a third light emitting device 223 to constitute a subpixel, and a driving chip 230 that drives the light emitting unit 220. The light emitting unit 220 may be electrically connected to a wiring electrode layer 120 by a conductive adhesive layer, for example, solder, conductive ball, etc.

On the wiring substrate 210, the light emitting unit 220 including the first light emitting device 221, the second light emitting device 222, and the third light emitting device 223 and a wiring (not shown) electrically connecting the driving chip 230 driving the light emitting unit 220 may be disposed. A description of the wiring will be omitted.

An encapsulation layer 240 is positioned on the wiring substrate 210 to cover the light emitting unit 220 and the driving chip 230. Also, a unit lens 260 is positioned on the encapsulation layer 240.

Here, the unit lens 260 refers to one lens entity other than a micro lens array 250. The unit lens 260 includes a single dome type lens. In other words, the unit lens 260 has a single convex lens shape. A directional angle of light emitted from the light emitting unit 220 may be diffused by the unit lens 260. That is, the directional angle of the light emitted from the light emitting unit 220 may be widened.

The unit lens 260 may have the same refractive index as the encapsulation layer 240.

As shown in FIG. 3, according to a third implementation, an individual light source 200 may include a wiring substrate 210, a light emitting unit 220 positioned on the wiring substrate 210 and including a first light emitting device 221, a second light emitting device 222, and a third light emitting device 223 to constitute a subpixel, and a driving chip 230 that drives the light emitting unit 220.

Also, an encapsulation layer 240 may be positioned on the wiring substrate 210 to cover the light emitting unit 220 and the driving chip 230. Also, a unit lens 261 may be positioned on the encapsulation layer 240.

The unit lens 261 may be formed to cover the light source 200 entirely. That is, as shown in FIG. 3, the unit lens 261 may be formed to have a shape that covers both side and upper surfaces of the encapsulation layer 240 and the wiring substrate 210. Also, the unit lens 261 may be formed to additionally cover a connection portion between a wiring electrode layer 120 and a conductive adhesive layer 140.

Also, the unit lens 261 may have a single dome shape as a whole. That is, the unit lens 261 may have a single convex lens shape.

Meanwhile, as shown in FIG. 4, according to a fourth implementation, a lens structure including a unit lens 260 may be attached onto an encapsulation layer 240. For example, a unit lens 260 may be attached by an adhesive layer 270. In this case, the adhesive layer 270 may have the same refractive index as the encapsulation layer 240.

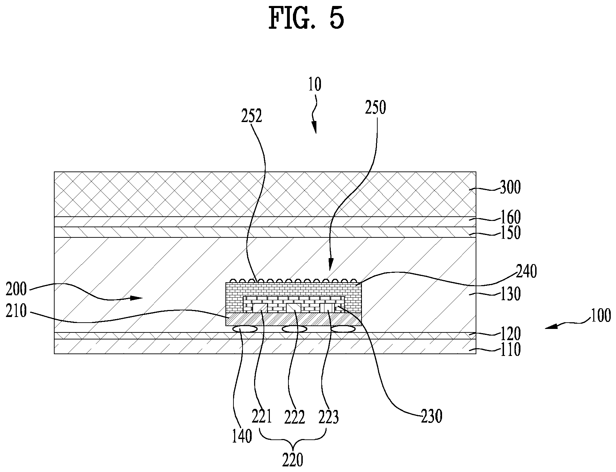

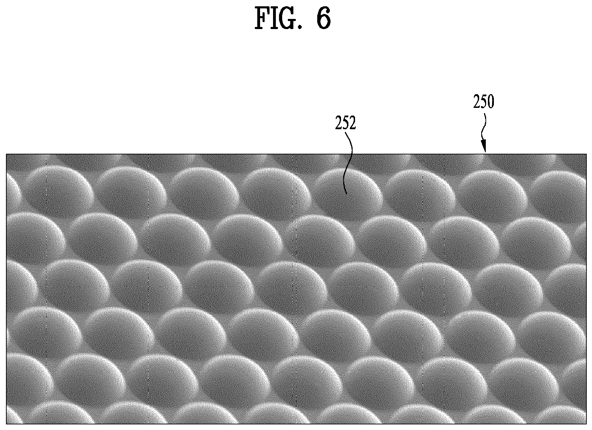

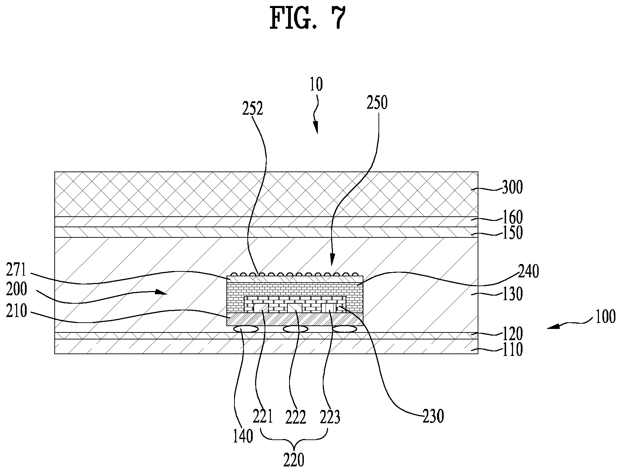

FIG. 5 is a schematic cross-sectional diagram showing a transparent display device according to a fifth example not forming part of the present invention. FIG. 6 is a photograph showing a micro lens array shape of a transparent display device according to the fifth example. Also, FIG. 7 is a schematic cross-sectional diagram showing a transparent display device according to a sixth example not forming part of the present invention.

Referring to FIG. 5, an individual light source 200 may include a wiring substrate 210, a light emitting unit 220 positioned on the wiring substrate 210 and including a first light emitting device 221, a second light emitting device 222 and a third light emitting device 223 to constitute a subpixel, and a driving chip 230 that drives the light emitting unit 220.

Also, an encapsulation layer 240 may be positioned on the wiring substrate 210 to cover the light emitting unit 220 and the driving chip 230. Also, a lens structure 250 may be positioned on the encapsulation layer 240. The lens structure 250 may include a micro lens array 252.

According to the present implementation, unlike the first implementation, the micro lens array 252 may be separately formed on the encapsulation layer 240. That is, the micro lens structure may be formed on an upper surface of the encapsulation layer 240 in the form shown in FIG. 6.

The micro lens array 252 may be formed of a resin material such as epoxy, silicon, acryl, or the like.

Meanwhile, as shown in FIG. 7, according to a sixth implementation, a micro lens array 252 may be located on a separate base substrate 271. That is, for convenience of handling, the micro lens array 252 may be formed on the base substrate 271 and positioned on the encapsulation layer 240. On the other hand, the base substrate 271 may be positioned on the encapsulation layer 240, and the micro lens array 252 may be formed on the base substrate 271.

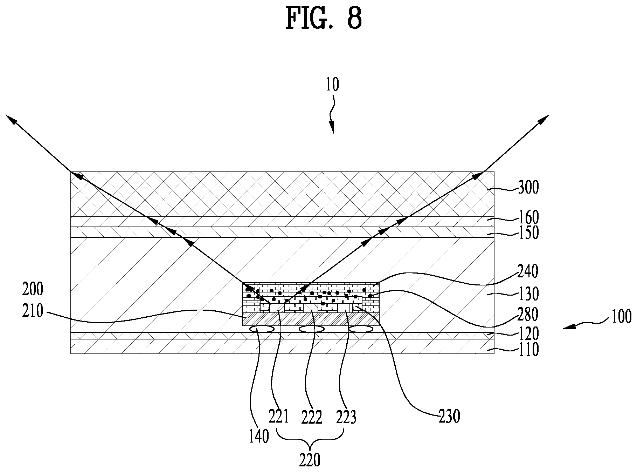

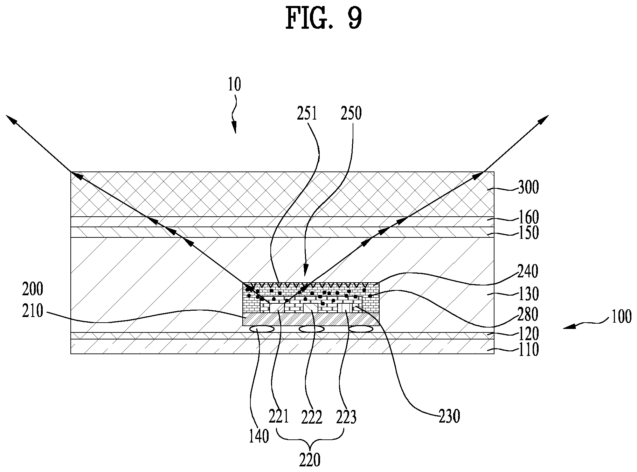

FIG. 8 is a schematic cross-sectional diagram illustrating a transparent display device according to a seventh example not forming part of the present invention. FIG. 9 is a schematic cross-sectional diagram illustrating a transparent display device according to an eighth example not forming part of the present invention.

Referring to FIG. 8, an individual light source 200 may include a wiring substrate 210, a light emitting unit 220 positioned on the wiring substrate 210 and including a first light emitting device 221, a second light emitting device 222, and a third light emitting device 223 to constitute a subpixel, and a driving chip 230 that drives the light emitting unit 220.

Also, an encapsulation layer 240 may be positioned on the wiring substrate 210 to cover the light emitting unit 220 and the driving chip 230. Here, a lens structure 250 on the encapsulation layer 240 is omitted.

Meanwhile, a light scattering agent 280 may be included in the encapsulation layer 240. For example, particles of the light scattering agent 280 s may be dispersed and distributed in the encapsulation layer 240. In this case, the light scattering agent 280 may be made of various oxides. For example, the light scattering agent 280 may be any one of silicon oxide (SiOₓ), titanium oxide (TiOₓ), and zinc oxide (ZnOₓ).

A refractive index of the light scattering agent 280 may be 1.4 to 1.6. A directional angle of light emitted from the light emitting unit 220 may be enlarged by the light scattering agent 280.

Referring to FIG. 9, as an eighth example in which an encapsulation layer 240 including a light scattering agent 280 is located and in which a lens structure 250 is provided on the encapsulation layer 240.

As shown in FIG. 9, the lens structure 250 may include a micro lens array 251 positioned on an upper surface of the encapsulation layer 240. The micro lens array 251 may be directly formed on the encapsulation layer 240.

That is, FIG. 9 illustrates a state in which the light scattering agent 280 is additionally configured in the structure of the light source 200 according to the first implementation. Accordingly, light scattering occurs primarily by the light scattering agent 280, and thereafter, secondary refraction occurs by the lens structure 250, thereby securing a wider directional angle.

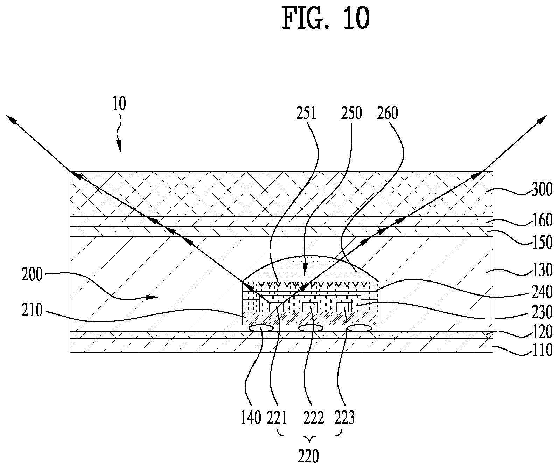

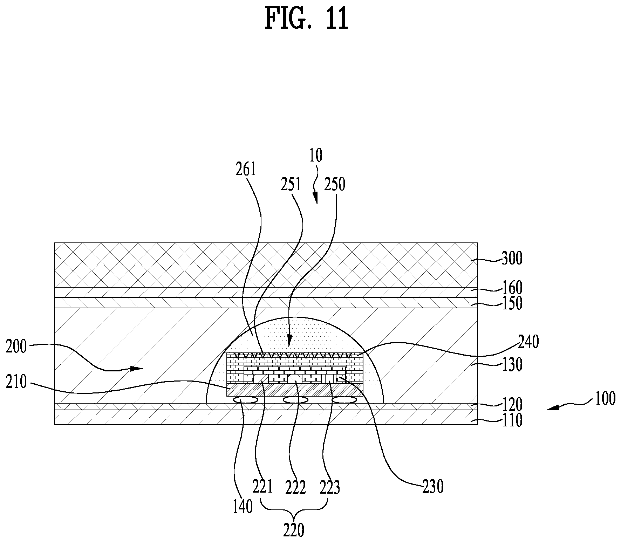

FIG. 10 is a schematic cross-sectional diagram illustrating a transparent display device according to a first embodiment of the present invention. FIG. 11 is a schematic cross-sectional diagram illustrating a transparent display device according to a second embodiment of the present invention.

Referring to FIG. 10, as a first embodiment in which a lens structure 250 is provided on an encapsulation layer 240 of a light source 200 is illustrated.

As shown in FIG. 10, the lens structure 250 includes a micro lens array 251 positioned on an upper surface of the encapsulation layer 240. The micro lens array 251 may be directly formed on the encapsulation layer 240. A unit lens 260 is positioned on the lens structure 250. The unit lens 260 may be the same as the unit lens 260 as shown in FIG. 2, in other words, the lens unit has a single convex lens shape.

That is, FIG. 10 shows a state in which the unit lens 260 according to the second example is additionally configured in the structure of the light source 200 according to the first example.

Meanwhile, referring to FIG. 11, as a second embodiment, a unit lens 261 covering a light source 200 entirely is provided on an encapsulation layer 240 of the light source 200.

As shown in FIG. 11, the unit lens 261 may be formed to cover both side and upper surfaces of the encapsulation layer 240 and a wiring substrate 210. Also, the unit lens 261 may be formed to additionally cover a connection portion between a wiring electrode layer 120 and a conductive adhesive layer 140.

Also, the unit lens 261 has a single convex lens shape.

The unit lens 261 may be the same as the unit lens 261 of the third example described above with reference to FIG. 3.

That is, FIG. 11 illustrates a state in which the unit lens 261 according to the third example is additionally configured in the structure of the light source 200 according to the first example.

The unit lens 260/261 may be applicable when it is directly formed on a lens structure 250 including a micro lens array 251. The unit lens 260/261 may be formed on the lens structure 250 by a dispensing method.

Light emitted from the light emitting unit 220 may be primarily refracted through the micro lens array 251, and then secondarily refracted and diffused by the unit lens 260/261. Accordingly, a directional angle of a wider angle may be secured.

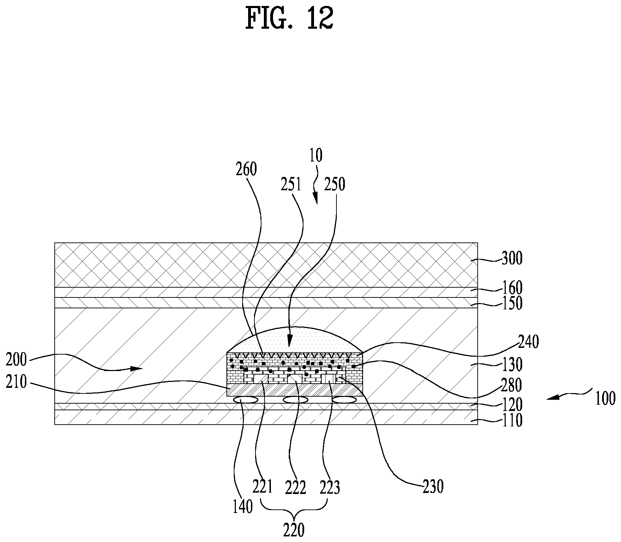

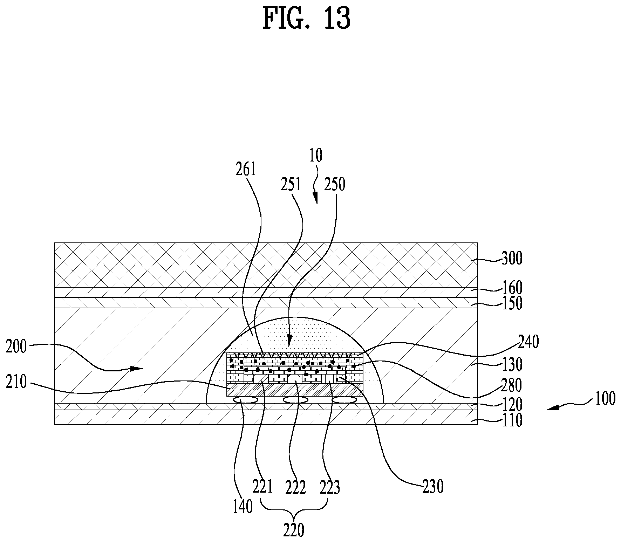

FIG. 12 is a schematic cross-sectional diagram illustrating a transparent display device according to a third embodiment of the present invention. FIG. 13 is a schematic cross-sectional diagram illustrating a transparent display device according to a twelfth implementation of the present disclosure.

Referring to FIG. 12, an individual light source 200 may include a wiring substrate 210, a light emitting unit 220 positioned on the wiring substrate 210 and including a first light emitting device 221, a second light emitting device 222, and a third t light emitting device 223 to constitute a subpixel , and a driving chip 230 that drives the light emitting unit 220.

Also, an encapsulation layer 240 may be positioned on the wiring substrate 210 to cover the light emitting unit 220 and the driving chip 230. Here, a lens structure 250 is formed on the encapsulation layer 240. The lens structure 250 includes a micro lens array 251. The micro lens array 251 may be formed directly on the encapsulation layer 240.

A light scattering agent 280 may be included in the encapsulation layer 240. For example, particles of the light scattering agent 280 may be dispersed and distributed in the encapsulation layer 240.

A unit lens 260 is located on the lens structure 250. The unit lens 260 may be the same as the unit lens 260 shown in

In other words, FIG. 12 shows a state in which the unit lens 260 according to the second example is additionally configured in the structure of the light source 200 according to the eighth example described in FIG. 9.

On the other hand, referring to FIG. 13, as a fourth embodiment of the present invention, a unit lens 261 covering a light source 200 entirely is provided on an encapsulation layer 240 of the light source 200.

As shown in FIG. 13, the unit lens 261 may be formed to cover both side and upper surfaces of the encapsulation layer 240 and a wiring substrate 210. Also, the unit lens 261 may be formed to additionally cover a connection portion between a wiring electrode layer 120 and a conductive adhesive layer 140.

A light scattering agent 280 may be included in the encapsulation layer 240. For example, particles of the light scattering agent 280 may be dispersed and distributed in the encapsulation layer 240.

The unit lens 261 may be the same as the unit lens 261 of the third example described above with reference to FIG. 3.

In other words, FIG. 13 shows a state in which the unit lens 261 according to the third example is additionally configured in the structure of the light source 200 according to the eight example.

Light emitted from the light emitting unit 220 may be primarily scattered by the light scattering agent 280, then secondarily refracted through the micro lens array 251, and thirdly refracted and diffused by the unit lens 260/261. Accordingly, a directional angle of a wider angle may be secured.

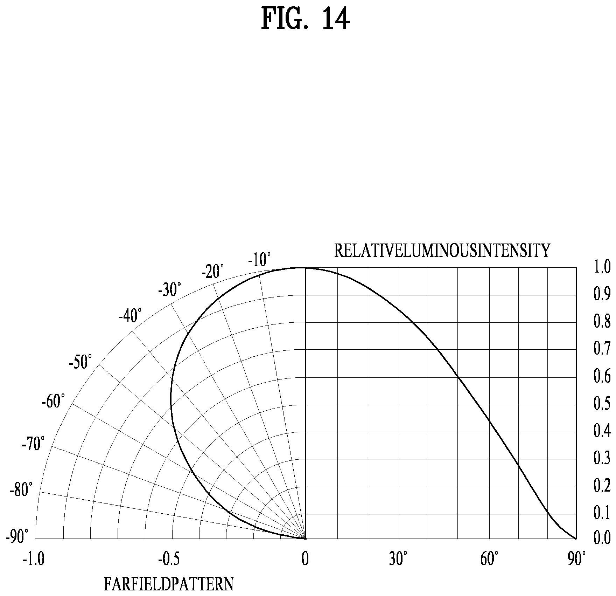

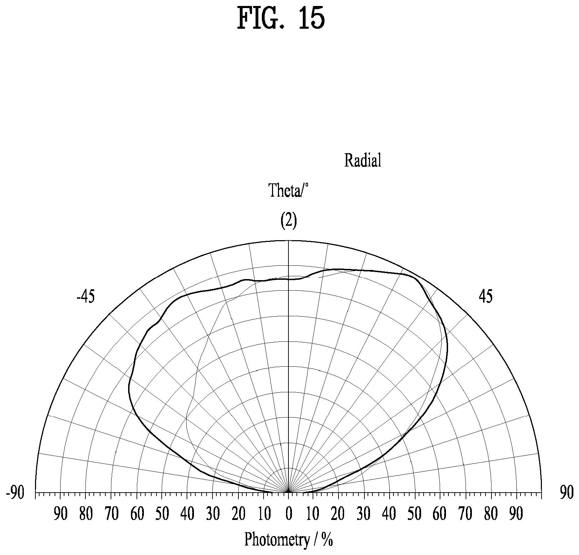

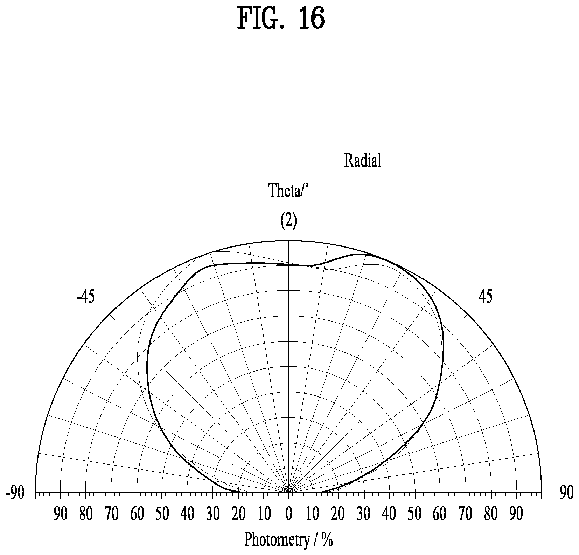

FIG. 14 is a graph showing a directional angle pattern of a light emitting device of a transparent display device according to an implementation of the present disclosure. FIG. 15 is a graph showing a directional angle pattern when a lens structure of a transparent display device according to an implementation of the present disclosure is applied. Also, FIGS. 16 to 18 are graphs showing a directional angle pattern when a light scattering agent of a transparent display device according to an implementation of the present disclosure is applied.

FIG. 14 illustrates a directional angle pattern by light emission of a red light emitting device 221 as an example of a light emitting device. The directional characteristic of the red light emitting device 221 may be formed as Lambertian.

According to characteristics of the light emitting device 221 itself, both the horizontal half width FWHM and the vertical half width may be 120 degrees.

FIG. 15 shows a directional angle pattern when the lens structure 250 is applied to the light emitting device 221. Here, a light line represents a horizontal half width and a dark line represents a vertical half width. Referring to FIG. 15, a horizontal half width is 117 degrees and a vertical half width is 132 degrees.

As such, it may be seen that the vertical half width is increased by the lens structure 250. FIG. 15 shows a structure in which the driving chip 230 is positioned together with the light emitting device. In this case, it may be seen that a part of light is absorbed in the driving chip 230 such that a directional angle pattern and a half width are asymmetrically formed.

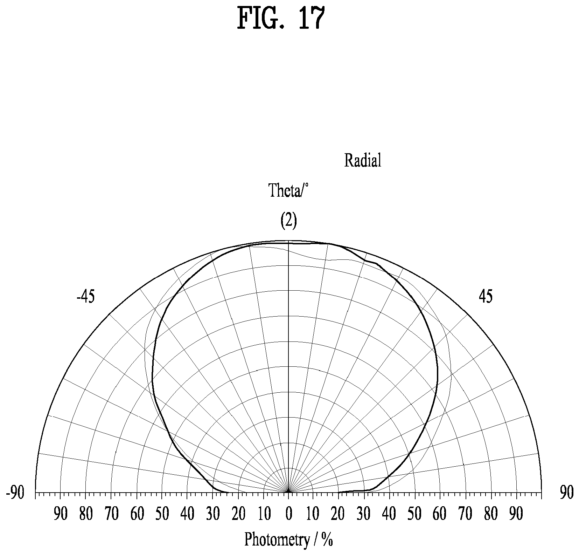

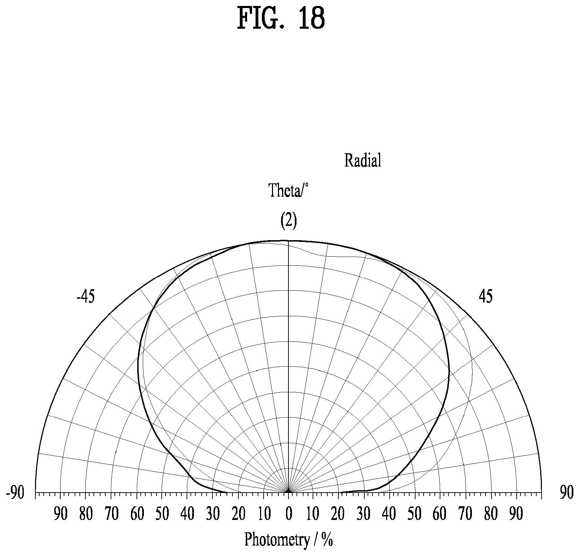

FIGS. 16 to 18 illustrate directional angle patterns when the lens structure 250 and the light scattering agent 280 are used together on the light emitting device 221. Here, FIG. 16 illustrates a case in which the light scattering agent 280 is used in an amount of 2% of the encapsulation layer 240, and FIGS. 17 and 18 illustrate cases in which the light scattering agent 280 is used in contents of 5% and 7% of the encapsulation layer 240, respectively.

According to the case of FIG. 16, it may be seen that a horizontal half width is 135 degrees and a vertical half width is 133 degrees. According to the case of FIG. 17, it may be seen that a horizontal half width is 141 degrees and a vertical half width is 134 degrees. In addition, according to the case of FIG. 18, it may be seen that a horizontal half width is 143 degrees and a vertical half width is 137 degrees.

Referring to FIGS. 16 to 18, the directional angle distribution may be substantially symmetrical and the optical intensity may be uniform for each content of the light scattering agent 280 by using the light scattering agent 280.

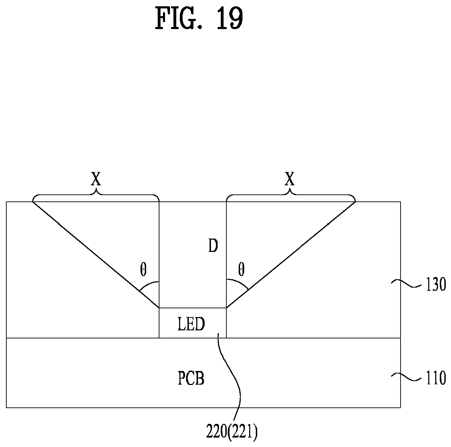

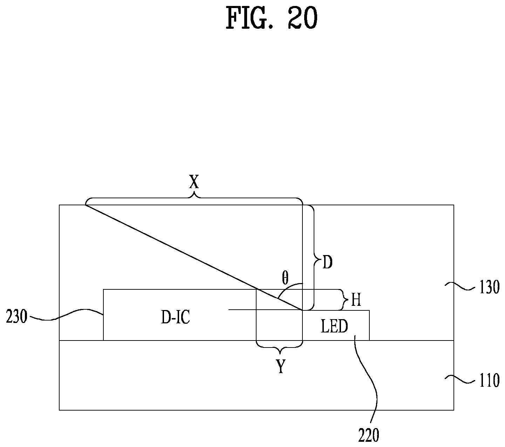

FIGS. 19 and 20 are conceptual diagrams illustrating relative positions of a light emitting device and a driving chip.

Referring to FIG. 19, a viewing angle (2θ) of a light emitting device 221 forming a light emitting unit 220 positioned on a substrate (e.g., a transparent film layer) 110 may be about 120 degrees or 140 degrees. Here, the light emitting unit 220 and the light emitting device 221 are described interchangeably.

Considering a directional angle of the light emitting device 221 constituting the light emitting unit 220, an effective area by a radius X of light located on a planarization layer 130 covering a light source 200 may be set.

Therefore, when the light source 200 is designed, an effective area in which light is emitted may be set in consideration of a package size of the light emitting unit 220.

Meanwhile, as shown in FIG. 20, when a driving chip 230 driving a light emitting unit 220 is located on one side of a light emitting device 221, a gap between the light emitting device 220 and the driving chip 230 may be important.

In this case, the driving chip 230 may be spaced apart from the light emitting unit 220 at a distance greater than or equal to an effective distance Y that prevents light emitted from the light emitting unit 220 from being blocked.

Namely, if H is the height at which the light emitted from the light emitting unit 220 is blocked due to the driving chip 230, this height H may correspond to a height difference between the driving chip 230 and the light emitting unit 220.

Considering this height difference, an effective distance Y between the driving chip 230 and the light emitting unit 220 may be considered through the relationship (Y = H × tan θ) between the effective distance Y, the height H, and the direction angle θ.

Through this process, when the driving chip 230 is close to the light emitting unit 220, the effective distance Y may be set based on the position of the light emitting unit 220.

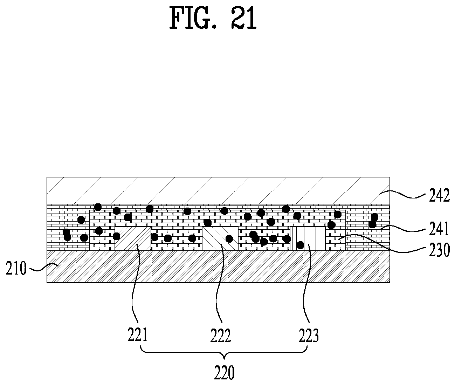

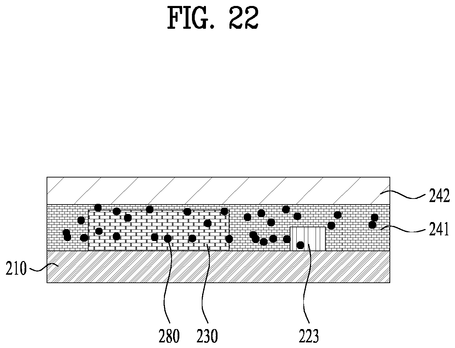

FIGS. 21 and 22 are cross-sectional schematic diagrams illustrating distribution of the light scattering agent.

As described above with reference to FIG. 8, the light scattering agent 280 may be distributed in the encapsulation layer 240. That is, the light scattering agent 280 may be freely distributed within the overall thickness of the encapsulation layer 240.

Meanwhile, as described above, when the driving chip 230 is embedded in the light source 200, as the light emitted from the light emitting unit 220 is absorbed by the driving chip 230, light loss may occur and a phenomenon effect such as a directional angle change and the like may occur.

As a part of preventing such a phenomenon, it is possible to adjust the distribution of the light scattering agent 280 in the encapsulation layer 240 having a predetermined thickness. That is, the encapsulation layer 240 may be divided into two parts 241 and 242 so that the light scattering agent 280 is distributed only on one side.

Accordingly, the encapsulation layer 240 may include a first layer 241 including the light scattering agent 280 and a second layer 242 positioned on the first layer 241. Here, the light scattering agent 280 may not be included in the second layer 242.

To this end, for example, the light scattering agent 280 may sink to the periphery of the light emitting devices 221, 222, and 223 by gravity using a waiting time behind a curing process after coating of the first layer 241 in the encapsulation layer 240 is applied.

Thereafter, a curing process and a process of forming the second layer 242 may be performed. Through this process, layer separation of the encapsulation layer 240 may be performed.

By this process and structure, the light emitted from the light emitting unit 220 may be scattered by the light scattering agent 280 and emitted upward, thereby improving the directional angle of the light emitting unit 220.

According to the present disclosure having various embodiments as described above, the lens structure 250, the unit lens 260, and the light scattering agent 280 may be variously combined to have desired light emission characteristics.

According to an embodiment of the present disclosure, the directional angle of the light source may be improved. In addition, the light source may have a uniform viewing angle.

Such a uniform viewing angle allows a user to feel similar light intensity at various angles, thereby increasing the affinity of a transparent display.

Accordingly, a use environment of the transparent display may be variously produced, and thus the use environment may be further expanded.

In addition, according to an embodiment of the present disclosure, color reproducibility may be improved by allowing a light source to have a flat top surface effect, and overall thickness of the transparent display may be adjusted.

The features, structures, and effects described in the embodiments above are included in at least one embodiment of the present invention and are not necessarily limited to a single embodiment. Furthermore, the features, structures, and effects illustrated in each embodiment may be combined or modified by those skilled in the art to which the embodiments pertain, and applied to other embodiments. Therefore, the content related to such combinations and modifications, as long as within the scope defined by the claims, should be construed as being within the scope of the present invention.

Additionally, while the embodiments have been described above for illustrative purposes, they do not limit the scope of the present invention as defined by the claims. Those skilled in the art to which the present invention pertains will understand that various modifications and applications not exemplified above are possible without departing from the essential characteristics of the embodiments. For example, the individual components specifically shown in the embodiments may be modified and implemented. Any differences related to such modifications and applications should be construed as being within the scope of the present invention as defined by the appended claims.

### INDUSTRIAL APPLICABILITY

According to the present disclosure, a transparent display device using a Light Emitting Diode (LED) may be provided.

## Claims

1. A transparent display device (10), comprising:
a transparent base (100);
a plurality of light sources (200) installed on the transparent base to constitute individual pixels;
a planarization layer (130) provided to cover the light sources (200); and
a cover layer (150) disposed on the planarization layer (130),
wherein each of the light sources (200) comprises
a wiring substrate (210),
a light emitting unit (220) positioned on the wiring substrate (210) and having a first light emitting device (221), a second light emitting device (222), and a third light emitting device (223) to constitute a sub-pixel,
a driving chip (230) configured to drive the light emitting unit (220) and disposed on the wiring substrate (210),
an encapsulation layer (240) disposed on the wiring substrate (210) to cover the light emitting unit (220) and the driving chip (230),
a first lens (251) including a micro lens array disposed on the encapsulation layer, and
a second lens (260, 261) disposed on the micro lens array,
wherein the second lens has a single convex lens shape.

2. The transparent display device (10) of claim 1, wherein the encapsulation layer (240) comprises:
a first layer (241) including the light scattering agent (280); and
a second layer (242) disposed on the first layer (241).

3. The transparent display device (10) of claim 1, wherein the driving chip (230) is spaced apart from the light emitting unit (220) by a distance equal to or greater than an effective distance to prevent obstruction of the light emitted from the light emitting unit (220).

## Patentansprüche

1. Transparente Anzeigevorrichtung (10), umfassend:
eine transparente Basis (100);
eine Vielzahl von Lichtquellen (200), die auf der transparenten Basis angebracht sind, um einzelne Pixel zu bilden;
eine Planarisierungsschicht (130), die so vorgesehen ist, dass sie die Lichtquellen (200) abdeckt; und
eine auf der Planarisierungsschicht (130) angeordnete Deckschicht (150),
wobei jede der Lichtquellen (200) umfasst:
ein Verdrahtungssubstrat (210),
eine auf dem Verdrahtungssubstrat (210) angeordnete Lichtemissionseinheit (220) mit einer ersten Lichtemissionsvorrichtung (221), einer zweiten Lichtemissionsvorrichtung (222) und einer dritten Lichtemissionsvorrichtung (223), die zusammen ein Subpixel bilden,
einen Ansteuerchip (230), der zum Ansteuern der Lichtemissionseinheit (220) ausgebildet ist und auf dem Verdrahtungssubstrat (210) angeordnet ist,
eine auf dem Verdrahtungssubstrat (210) angeordnete Verkapselungsschicht (240) zum Abdecken der Lichtemissionseinheit (220) und des Ansteuerchips (230),
eine erste Linse (251), die ein auf der Verkapselungsschicht angeordnetes Mikrolinsenarray umfasst, und
eine zweite Linse (260, 261), die auf dem Mikrolinsenarray angeordnet ist, wobei die zweite Linse die Form einer einzelnen konvexen Linse aufweist.

2. Die transparente Anzeigevorrichtung (10) nach Anspruch 1, wobei die Verkapselungsschicht (240) umfasst:
eine erste Schicht (241), die das Lichtstreuungsmittel (280) enthält; und
eine zweite Schicht (242), die auf der ersten Schicht (241) angeordnet ist.

3. Die transparente Anzeigevorrichtung (10) nach Anspruch 1, wobei der Ansteuerchip (230) von der Lichtemissionseinheit (220) um einen Abstand beabstandet ist, der gleich oder größer als ein wirksamer Abstand ist, um eine Behinderung des von der Lichtemissionseinheit (220) emittierten Lichts zu verhindern.

## Revendications

1. Dispositif d'affichage transparent (10), comprenant :
une base transparente (100);
une pluralité de sources lumineuses (200) montées sur la base transparente pour constituer des pixels individuels;
une couche de planarisation (130) servant à recouvrir les sources lumineuses (200); et
une couche de recouvrement (150) disposée sur la couche de planarisation (130),
dans lequel chacune des source lumineuses (200) comprend
un substrat de câblage (210),
une unité électroluminescente (220) disposée sur le substrat de câblage (210) et comportant un premier dispositif électroluminescent (221), un deuxième dispositif électroluminescent (222) et un troisième dispositif électroluminescent (223) pour constituer un sous pixel,
une puce de commande (230) conçue pour commander l'unité électroluminescente (220) et disposée sur le substrat de câblage (210),
une couche d'encapsulation (240) disposée sur le substrat de câblage (210) pour recouvrir l'unité électroluminescente (220) et la puce de commande (230),
une première lentille (251) comprenant un réseau de microlentilles disposé sur la couche d'encapsulation, et
une deuxième lentille (260, 261) disposée sur le réseau de microlentilles, la deuxième lentille présentant la forme d'une lentille convexe simple.

2. Dispositif d'affichage transparent (10) selon la revendication 1, dans lequel la couche d'encapsulation (240) comprend:
une première couche (241) comprenant l'agent de diffusion de la lumière (280); et
une deuxième couche (242) disposée sur la première couche (241).

3. Dispositif d'affichage transparent (10) selon la revendication 1, dans lequel la puce de commande (230) est disposée à l'écart de l'unité électroluminescente (220) à une distance supérieure ou égale à une distance efficace pour empêcher l'obstruction de la lumière émise par l'unité électroluminescente (220).
